(19) Europäisches Patentamt
European Patent Office
Office européen des brevets

(11) EP 1 944 864 A2

(12) **EUROPÄISCHE PATENTANMELDUNG**

(43) Veröffentlichungstag:
**16.07.2008 Patentblatt 2008/29**

(51) Int Cl.:
**H03D 7/18** (2006.01)

(21) Anmeldenummer: **08000320.5**

(22) Anmeldetag: **09.01.2008**

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**
Benannte Erstreckungsstaaten:
**AL BA MK RS**

(30) Priorität: **09.01.2007 DE 102007001425**

(71) Anmelder: **Rohde & Schwarz GmbH & Co. KG 81671 München (DE)**

(72) Erfinder:
• **Dressel, Wolfgang Dr.**
  **82194 Gröbenzell (DE)**
• **Roth, Alexander**
  **84405 Dorfen (DE)**

(74) Vertreter: **Körfer, Thomas et al Mitscherlich & Partner Patent- und Rechtsanwälte Sonnenstrasse 33 80331 München (DE)**

(54) **Frequenzumsetzer**

(57) Ein Frequenzumsetzer hat ein Vorselektionsfilter (1), einem Mischer (2) und einem Lokaloszillator (3). Hierbei ist das Vorselektionsfilter (1), der als Bandpass arbeitet, ab einer Minimalfrequenz ($f_{min}$) bis zu einer Maximalfrequenz ($f_{max}$) für Eingangsfrequenzen durchlässig. Der Mischer (2) mischt ein vorselektiertes Eingangsignal am Ausgang des Vorselektionsfilters (1) mit einem Lokaloszillator-Signal des Lokaloszillators (3). Die Maximalfrequenz ($f_{max}$) des Vorselektionsfilters (1) ist kleiner als die Lokaloszillator-Frequenz ($f_{LO}$) zuzüglich der halben Zwischenfrequenz ($f_{ZF}/2$).

Fig. 1

EP 1 944 864 A2

**Beschreibung**

Die Erfindung betrifft einen Frequenzumsetzer, insbesondere für einen Messempfänger.

Messempfänger für Messzwecke, insbesondere für Spektrumanalysatoren, haben beim heutigen Stand der Technik hervorragende messtechnische Eigenschaften. Nachteilig sind jedoch aufwendige Filtermaßnahmen zur Reduzierung von Störfrequenzen, insbesondere Spiegelfrequenzen, die ansonsten das Messergebnis verfälschen würden. So wird bei gängigen Spektrumanalysatoren ein Überlagerungsempfänger mit einer relativ hoch liegenden ersten Zwischenfrequenz und noch höherer Frequenz des ersten Lokaloszillators eingesetzt. Die Frequenzdifferenz entspricht dann der Messfrequenz, durch Mischung ergibt sich die erste Zwischenfrequenz.

Ein Funkmessempfänger für einen Spektrumanalysator nach dem Oberbegriff des Anspruchs 1 ist z. B. aus der DE 195 30 812 C2 bekannt. Das Eingangssignal RF wird dort über eine Vorstufe mit einem Breitbandverstärker zum ersten Mischer geleitet. Dort wird es mit dem über den I/Q-Modulator geführten Oszillatorsignal des ersten Lokaloszillators gemischt. Die zwischenfrequenten Mischprodukte werden in der ZF-Stufe selektiert, d. h. es werden nur nahe bei der Zwischenfrequenz liegende Mischprodukte durchgelassen und weiterverstärkt. Dies sind genau die Empfangssignale, welche bei Oszillatorfrequenz + Zwischenfrequenz und bei Oszillatorfrequenz - Zwischenfrequenz liegen. Nach der ZF-Stufe, wird das Signalgemisch einem I/Q-Demodulator zugeführt. Sowohl der Interphase-Anteil als auch der Quadraturphase-Anteil werden einer Analog/Digital-Wandlung unterzogen und die resultierenden Digitaldaten werden von einem Signalprozessor eines Mikrocomputer-Systems weiterverarbeitet.

Nachteilig an dem aus der DE 195 30 812 C2 bekannten Frequenzumsetzer ist insbesondere die breitbandige Erfassung der Hochfrequenz-Signale und der daraus folgende Aufwand bei der Nachbearbeitung durch digitale Signalverarbeitung.

Die Aufgabe der vorliegenden Erfindung besteht darin, eine direkte Methode der Signalfilterung bereitzustellen, die keine relevanten Mischprodukte zulässt.

Die Aufgabe wird erfindungsgemäß gelöst durch die Merkmale des Anspruchs 1. Vorteilhafte Weiterbildungen sind Gegenstand der hierauf rückbezogenen Unteransprüche.

Erfindungsgemäß erfolgt die vorteilhafte Auswahl der Empfangsfrequenzen mit einem Vorselektionsfilter, das als Bandpass nur ab einer Minimalfrequenz bis zu einer Maximalfrequenz für die Eingangssignal-Frequenzen durchlässig ist. Hierbei greift ein Mischer das vorselektierte Eingangsignal am Ausgang des Vorselektionsfilters auf und mischt es mit einem Lokaloszillator-Signal eines Lokaloszillators zu einem Zwischenfrequenz-Signal. Die Lokaloszillator-Frequenz zuzüglich der halben Zwischenfrequenz ist vom Betrag größer als die Maximalfrequenz, bis zu der das Vorselektionsfilter durchlässig ist.

Eine weitere vorteilhafte Ausgestaltung ist, dass das Vorselektionsfilter 1 an seiner Untergrenze erst oberhalb des Betrags der zweifachen Lokaloszillatorfrequenz abzüglich der Zwischenfrequenz durchlässig ist. Diese Vorgehensweise schließt von vorne herein alle besonders störenden Mischprodukte, die bei der Überlagerung im Mischer entstehen können, aus.

In einer weiteren vorteilhaften Ausgestaltung ist dem Mischer ein weiteres Selektionsfilter nachgeschaltet. Das weitere Selektionsfilter ist bevorzugt ein abstimmbares Filter. Vorteilhafterweise ist das weitere Selektionsfilter ein Yttrium-Eisengranat - Filter (YIG-Filter). So werden verbleibende störende Mischprodukte vor der Weiterverarbeitung des Zwischenfrequenzsignals entfernt.

Die Eingangsfrequenz des Frequenzumsetzers liegt vorteilhafterweise im Bereich von 25 GHz bis 100 GHz, bevorzugt im Bereich von 40 GHz bis 75 GHz, besonders bevorzugt im Bereich von 50 GHz bis 67 GHz. Die Frequenz des Lokaloszillator-Signals liegt vorteilhafterweise im Bereich von 20 GHz bis 70 GHz, bevorzugt im Bereich von 34 GHz bis 50 GHz, besonders bevorzugt im Bereich von 40 GHz bis 47 GHz. Die Frequenz des Zwischenfrequenz-Signals liegt vorteilhafterweise im Bereich von 5 GHz bis 30 GHz, bevorzugt im Bereich von 6 GHz bis 25 GHz, besonders bevorzugt im Bereich von 10 GHz bis 20 GHz. So ist eine Verarbeitung von Signalen eines breiten Frequenzbereichs möglich.

Nachfolgend wird die Erfindung anhand der Zeichnung, in der ein vorteilhaftes Ausführungsbeispiel der Erfindung schematisch dargestellt ist, beschrieben. In der Zeichnung zeigen:

Fig. 1    ein Blockschaltbild eines ersten erfindungsgemäßen Frequenzumsetzers nach dem Überlagerungsprinzip;

Fig. 2    ein Blockschaltbild eines zweiten erfindungsgemäßen Frequenzumsetzers nach dem Überlagerungsprinzip;

Fig. 3    das Frequenzspektrum bei einer Frequenzumsetzung, und

Fig. 4    ein Diagramm mit verschiedenen Mischprodukten.

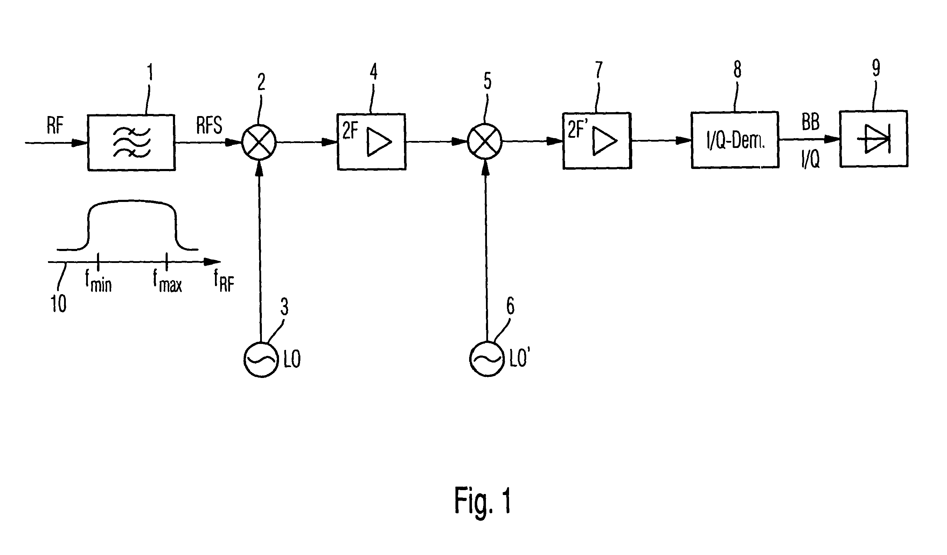

In der Fig. 1 ist das Blockschaltbild eines ersten erfindungsgemäßen Frequenzumsetzers mit einem Vorselektionsfilter 1 und unterhalb ein Diagramm der Filterkurve 10 des Vorselektionsfilters 1 dargestellt. In dem Diagramm 10 ist die Minimalfrequenz $f_{min}$ und die Maximalfrequenz $f_{max}$ über der Eingangsfrequenz $f_{RF}$ des Vorselektionsfilters abgebildet. Zwischen diesen beiden Frequenzen $f_{min}$ und $f_{max}$ ist das Filter für jede Frequenz des Hochfrequenz-Eingangssignals RF durchlässig. Die geschickte Wahl der Minimalfrequenz $f_{min}$ und der Maximalfrequenz $f_{max}$ ist dabei entscheidend. Der nachfolgende Mischer 2 mischt das gefilterte Hochfrequenz-Eingangssignal RFS mit dem Signal LO des Lokaloszillators 3 zu einem ersten Zwischenfrequenz-Signal ZF, das dem ersten Zwischenfrequenz-Verstärker 4 zugeführt wird. Dabei werden die Frequenz des Lokaloszillatorsignals LO und damit auch die Frequenz des Zwischenfrequenz-Signals ZF so gewählt, dass unerwünschte Mischprodukte durch das Vorselektionsfilter 1 bestmöglich unterdrückt werden. In dem dargestellten Ausführungsbeispiel liegt die Frequenz des Lokaloszillatorsignals bei einer Eingangsfrequenz von 50 bis 67 GHz zwischen 40 und 47 GHz. Die resultierende Zwischenfrequenz beträgt damit zwischen 10 und 20 GHz. Der Zwischenfrequenz-Verstärker 4 verstärkt das Zwischenfrequenz-Signal ZF und gibt es anschließend im Ausführungsbeispiel an einen weiteren Mischer 5 weiter, der das erste Zwischenfrequenz-Signal ZF mit dem Signal LO' eines weiteren Lokaloszillators 6 mischt. In diesem Ausführungsbeispiel beträgt die zweite Zwischenfrequenz 10,4 bis 20,4 GHz. Damit ergibt sich eine feste zweite Zwischenfrequenz von 400 MHz. Der nachfolgende zweite Zwischenfrequenz-Verstärker 7 verstärkt das zweite Zwischenfrequenz-Signal ZF' und gibt es an den I/Q-Demodulator 8 weiter, der einen Inphase-Anteil I und einen Quadraturphase-Anteil Q des Basisband-Signals BB erzeugt. Vom I/Q-Demodulator 8 wird das Basisband-Signal BB in den Detektor 9 geleitet. Eine weitere Frequenzumsetzung des zweiten Zwischenfrequenzsignals ZF' in einen niedrigeren Frequenzbereich, z.B. in den kHz-Bereich vor Zuführung zu dem I/Q-Demodulator 8 ist ebenfalls denkbar.

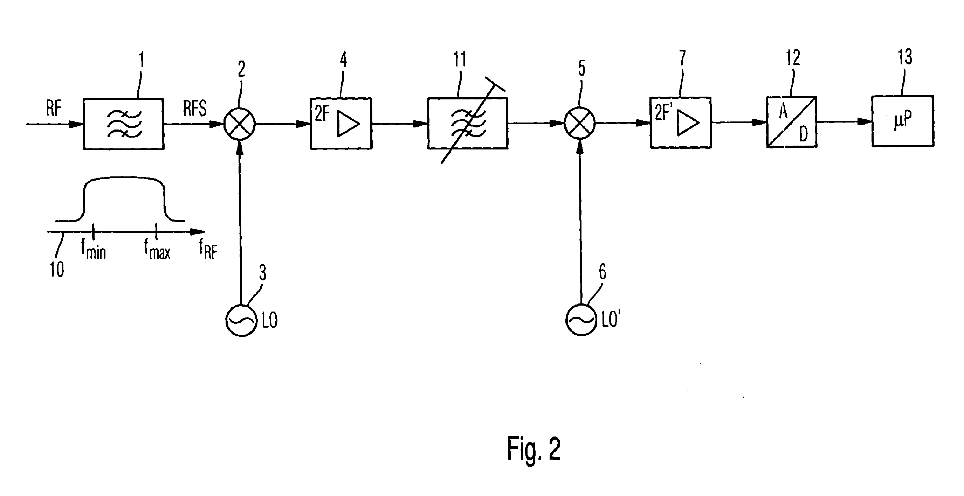

In der Fig. 2 ist ein Blockschaltbild eines zweiten erfindungsgemäßen Frequenzumsetzers dargestellt. In diesem beispielhaften erfindungsgemäßen Frequenzumsetzer verstärkt der Zwischenfrequenz-Verstärker 4 das Zwischenfrequenz-Signal ZF und gibt es anschließend an ein weiteres Selektionsfilter 11 weiter. Dieses Selektionsfilter 11 ist als Yttrium-Eisengranat - Filter (YIG-Filter) ausgeführt. Es handelt sich dabei um ein Filter mit magnetisch abstimmbarem Durchlassfrequenzbereich. Das gefilterte Signal wird an den weiteren Mischer 5 weitergegeben, der das gefilterte erste Zwischenfrequenz-Signal ZF mit dem Signal LO' eines weiteren Lokaloszillators 6 mischt. So ist eine eindeutige Mischung auf die zweite Zwischenfrequenz gewährleistet.

Die Verwendung einer variablen ersten Zwischenfrequenz ist so möglich. Der nachfolgende zweite Zwischenfrequenz-Verstärker 7 verstärkt das zweite Zwischenfrequenz-Signal ZF' und gibt es an den A/D-Wandler 12 weiter, der das Signal digitalisiert. Das digitalisierte Signal wird zur Weiterverarbeitung an einen Prozessor 13 weitergeleitet.

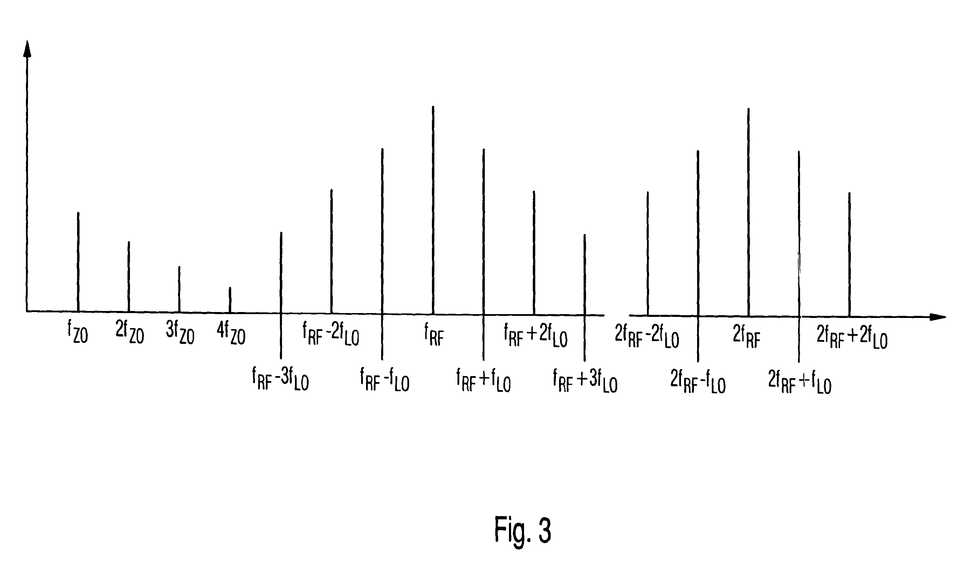

In dem Diagramm der Fig. 3 wird ein Frequenzspektrum mit Mischprodukten aus einem Eingangs-Signal RF mit der Frequenz $f_{RF}$ und aus dem Lokaloszillator-Signal LO mit der Frequenz $f_{LO}$ bei der Frequenzumsetzung dargestellt. Die Frequenzen $f_{min}$ und $f_{max}$ sind die minimale und maximale Eingangsfrequenz. Dabei treten die Mischfrequenzen $f_K = |\pm m f_{RF} \pm n f_{LO}|$ auf, für m,n=0,1,2,3. Für den Fall m=0 bzw. n=0 erhält man die Eingangsfrequenz bzw. die Lokaloszillator-Frequenz und deren Oberschwingungen (Frequenzvervielfachung). Für m,n≠0 ergeben sich Mischfrequenzen.

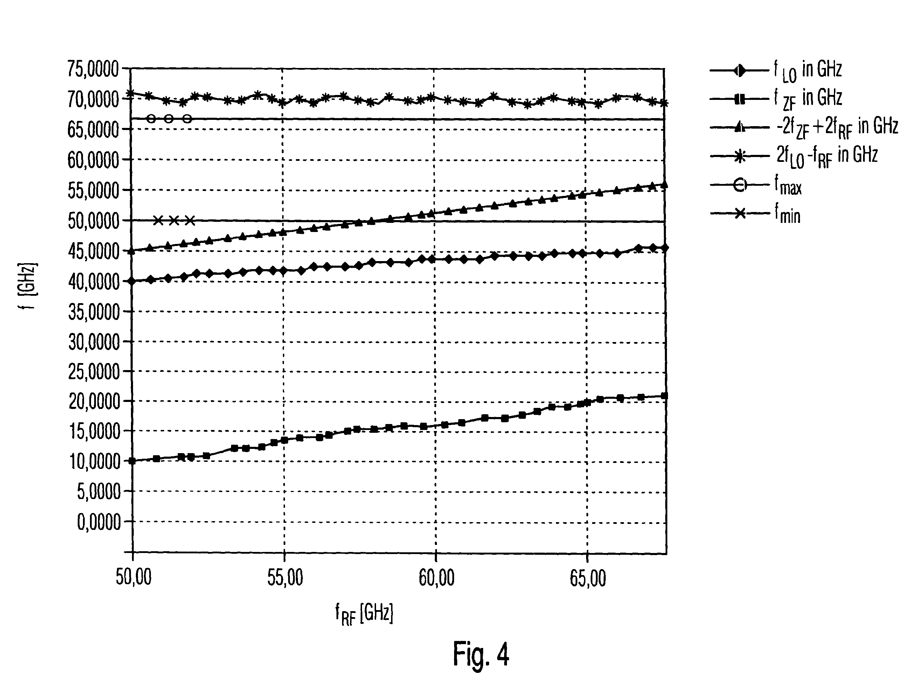

In dem Diagramm der Fig. 4 ist die Wirkung des Frequenzumsetzers deutlich gemacht. Auf der Abzisse ist die gewünschte Empfangsfrequenz $f_{RF}$ und auf der Ordinate ist die Frequenz f verschiedener Signale dargestellt. Dabei sind im Diagramm die Verläufe der Lokaloszillator-Frequenz $f_{LO}$ des ersten Lokaloszillators 3, die der Zwischenfrequenz $f_{ZF}$ am Eingang des ersten Zwischenfrequenz-Verstärkers 4 und die sich als besonders störend erweisenden Mischprodukte $-2f_{LO}+2f_{RF}$ sowie $2f_{LO}-f_{RF}$ über der Eingangsfrequenz $f_{RF}$ am Eingang des Vorselektionsfilters 1 dargestellt. Man erkennt, dass in den Bereich zwischen der Zwischenfrequenz $f_{ZF}$ und der Frequenz des Lokaloszillators $f_{LO}$ keine besonders störenden Mischprodukte fallen. Das Mischprodukt $-2f_{LO}+2f_{RF}$ liegt noch recht nahe bei der Frequenz des Lokaloszillators $f_{LO}$ und das Mischprodukt $2f_{LO}-f_{RF}$ liegt deutlich über der Frequenz $f_{LO}$ des Lokaloszillators 3. Die Mischprodukte $-2f_{LO}+2f_{RF}$ und $2f_{LO}-f_{RF}$ sind die am meisten störenden Mischprodukte, die durch das Vorselektionsfilter 1 unterdrückt werden müssen.

Wie man aus Fig. 4 erkennt, sind die beiden unerwünschten Mischprodukte $-2f_{LO}+2f_{RF}$ und $2f_{LO}-f_{RF}$ besonders störend, da sie als unerwünschte Mischprodukte in die erste Zwischenfrequenz $f_{ZF}$ fallen können, so dass der Messempfänger nicht nur auf der erwünschten Empfangsfrequenz $f_{RF}$, sondern auf weiteren Empfangsfrequenzen für ein Empfangssignal selektiv ist. Diese unerwünschte Selektivität auf den weiteren Empfangsfrequenzen wird erfindungsgemäß durch das Vorselektionsfilter 1 beseitigt, wobei erfindungsgemäß das Vorselektionsfilter 1 als Bandpass arbeitet und nur ab einer Minimalfrequenz ein $f_{min}$ bis zu einer Maximalfrequenz $f_{max}$ durchlässig ist. Um das unerwünschte Mischprodukt $-2f_{LO}+2f_{RF}=f_{ZF}$ zu beseitigen, ist die Maximalfrequenz $f_{max}$ des Vorsektionsfilters 1 so eingestellt, dass die diesem unerwünschten Mischprodukt entsprechende unerwünschte Empfangsfrequenz $f_{RF1}$ oberhalb der Maximalfrequenz des Vorselektionsfilters 1 liegt ($f_{RF1}>f_{max}$). Daraus ergibt sich die Bedingung:

$$f_{RF1} = \left| f_{LO} + \tfrac{1}{2} f_{ZF} \right| > f_{max} \qquad\qquad (1).$$

Entsprechend einer vorteilhaften Weiterbildung wird die Minimalfrequenz $f_{min}$ des als Bandpass arbeitenden Vorselektionsfilters 1 so eingestellt, dass die dem unerwünschten Mischprodukt $2f_{LO}\text{-}f_{RF}=f_{ZF}$ entsprechende unerwünschte Empfangsfrequenz $f_{RF2}$ unterhalb der Minimalfrequenz $f_{min}$ des Vorselektionsfilters 1 liegt ($f_{RF2}<f_{min}$). D. h. es gilt vorzugsweise zusätzlich die Bedingung:

$$f_{RF2} = \left| 2 \cdot f_{LO} - f_{ZF} \right| < f_{min} \qquad (2)$$

Da das Vorselektionsfilter natürlich eine endliche Flankensteilheit hat, ist es sinnvoll, die Maximalfrequenz $f_{max}$ und die Minimalfrequenz $f_{min}$ des Vorselektionsfilters 1 so zu wählen, dass die obigen Bedingungen (1) und (2) deutlich, d. h. mit einem entsprechenden frequenzmäßigen Sicherheitsabstand, erfüllt sind. Da das unerwünschte Mischprodukt $2 \cdot f_{LO}\text{-}f_{RF}$ als Mischprodukt oft einen kleineren Pegel hat als das unerwünschte Mischprodukt $-2 \cdot f_{LO}+2 \cdot f_{RF}$, ist die Einhaltung der obigen Bedingung (1) wichtiger als die Bedingung (2) und die Einhaltung der Bedingung (1) oftmals bereits ausreichend. Bevorzugt sollte aber auch die Bedingung (2) eingehalten werden.

Die Erfindung ist nicht auf das beschriebene Ausführungsbeispiel beschränkt. Insbesondere kann der erfindungsgemäße Frequenzumsetzer nicht nur in einem Messempfänger für Messzwecke, sondern auch in Funkempfängern zum Einsatz kommen.

**Patentansprüche**

1. Frequenzumsetzer mit einem Vorselektionsfilter (1), einem Mischer (2) und einem Lokaloszillator (3),
   wobei der Vorselektionsfilter (1) als Bandpass nur ab einer Minimalfrequenz ($f_{min}$) bis zu einer Maximalfrequenz ($f_{max}$) für Eingangsfrequenzen ($f_{RF}$) eines Eingangssignals (RF) durchlässig ist,
   wobei der Mischer (2) ein vorselektiertes Eingangssignal (RF) am Ausgang des Vorselektionsfilters (1) mit einem Lokaloszillator-Signal (LO) des Lokaloszillators (3) zu einem Zwischenfrequenz-Signal (ZF) mischt, und
   wobei die zweifache Lokaloszillator-Frequenz ($f_{LO}$) des Lokaloszillator-Signals (LO) zuzüglich der halben Zwischenfrequenz ($f_{ZF}/2$) des Zwischenfrequenz-Signals (ZF) vom Betrag ($|f_{LO}+\frac{1}{2}f_{ZF}|$) größer ist als die Maximalfrequenz ($f_{max}$) des Vorselektionsfilters (1).

2. Frequenzumsetzer nach Anspruch 1,
   **dadurch gekennzeichnet,**
   **dass** die zweifache Lokaloszillator-Frequenz ($2 \cdot f_{LO}$) abzüglich der Zwischenfrequenz ($f_{ZF}$) vom Betrag ($|2f_{LO}\text{-}f_{ZF}|$) kleiner ist als die Minimalfrequenz ($f_{min}$) des Vorselektionsfilters (1).

3. Frequenzumsetzer nach Anspruch 1 oder 2,
   **dadurch gekennzeichnet,**
   **dass** dem Mischer (2) ein weiteres Selektionsfilter (11) nachgeschaltet ist.

4. Frequenzumsetzer nach Anspruch 3,
   **dadurch gekennzeichnet,**
   **dass** das weitere Selektionsfilter (11) ein abstimmbares Filter ist.

5. Frequenzumsetzer nach Anspruch 3 oder 4,
   **dadurch gekennzeichnet,**
   **dass** das weitere Selektionsfilter (11) ein Yttrium-Eisengranat - Filter (YIG-Filter) ist.

6. Frequenzumsetzer nach einem der Ansprüche 1 bis 5,
   **dadurch gekennzeichnet,**
   **dass** die Eingangsfrequenz ($f_{RF}$) im Bereich von 25 GHz bis 100 GHz, bevorzugt im Bereich von 40 GHz bis 75 GHz, besonders bevorzugt im Bereich von 50 GHz bis 67 GHz liegt.

7. Frequenzumsetzer nach einem der Ansprüche 1 bis 6,
   **dadurch gekennzeichnet,**
   **dass** die Frequenz des Lokaloszillator-Signals (LO) im Bereich von 20 GHz bis 70 GHz, bevorzugt im Bereich von 34 GHz bis 50 GHz, besonders bevorzugt im Bereich von 40 GHz bis 47 GHz liegt.

8. Frequenzumsetzer nach einem der Ansprüche 1 bis 7,
   **dadurch gekennzeichnet,**
   **dass** die Frequenz des Zwischenfrequenz-Signals (ZF) im Bereich von 5 GHz bis 30 GHz, bevorzugt im Bereich von 6 GHz bis 25 GHz, besonders bevorzugt im Bereich von 10 GHz bis 20 GHz liegt.

Fig. 1

EP 1 944 864 A2

Fig. 2

RF → [1] ≈ → RFS → ⊗ [2] → [4] 2F ▷ → [11] ≈ → ⊗ [5] → [7] 2F' ▷ → [12] A/D → [13] μP

10 → f_min  f_max → f_RF

[3] LO

[6] LO'

EP 1 944 864 A2

Fig. 3

Fig. 4

EP 1 944 864 A2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19530812 C2